# EUROPEAN PATENT APPLICATION

(11) **EP 4 766 037 A1**
(43) Date of publication of application: **24.06.2026**
(21) Application number: 25214787.1
(22) Date of filing: 11.11.2025
(51) Int. Cl.: H05K 1/11, H05K 1/02, H05K 1/03, H05K 3/42

(54) **PRINTED WIRING BOARD**

(30) Priority: 18.12.2024 JP 2024221791
(71) Applicant: Japan Aviation Electronics Industry, Limited, Tokyo 150-0043 (JP)
(72) Inventor: YOSHINAKA, Akira, Tokyo, 150-0043 (JP)
(74) Representative: MERH-IP Matias Erny Reichl Hoffmann Patentanwälte PartG mbB

(57) **Abstract**

A printed wiring board includes a fiber-containing insulating plate including a fibrous base material, and a CAF-resistant wiring structure. The CAF-resistant wiring structure includes a ground conductor, a first conductor included in a power supply line, and a second conductor included in a signal line. The first conductor and the second conductor are present in a range where the first conductor and the second conductor can be short-circuited each other by a conductive anode filament. Furthermore, the ground conductor, the first conductor, and the second conductor are arranged in order of the first conductor, the ground conductor, and then the second conductor, in a direction in which the fibrous base material extends.

## Description

### TECHNICAL FIELD

The present disclosure relates to a printed wiring board for which countermeasures against failures due to conductive anodic filament (CAF) have been taken.

### BACKGROUND ART

In recent years, oil wells have been drilled further deeper and further longer. For example, oil-well drilling may reach a depth of 5 km and a distance of 10 km. To succeed this harsh drilling, it is important to know whether the drilling orbit traces a path as planned beforehand while enduring vibrations, impacts, high-temperature environment (the temperature at a site where a drill bit proceeds to drill to search for an oilfield often exceeds 150 degrees Celsius and may sometime exceed 200 degrees Celsius). A measurement while drilling (MWD) technique has been known in which drilling proceeds as the orientation (normally, inclination angle and azimuth angle) of the drill bit is measured on a real-time basis. According to the MWD technique, a device called a directional module including an acceleration sensor and a magnetic sensor for measuring the orientation of the drill bit is attached near the drill bit. Regarding the directional module, please refer to Hiroshi Arita and two others, "Development of Digital Directional Module", [online], March 2017, JAE Technical Report No. 39, [searched on November 20, 2024], internet <URL: https://www.jae.com/corporate/rd/tech-report/39/>.

Inside the directional module, a printed wiring board is normally incorporated. On the printed wiring board, a printed component or an electronic component is mounted. As the structure of the printed wiring board, a double-sided board and a multilayer board have been known. Since the structure of the printed wiring board has been known well, it is not required to list literatures.

Terms regarding the printed circuit are defined in International Electrotechnical Commission (IEC) 60194:2015, Japanese Industrial Standards (JIS) C 5603, and so forth. However, in reality, common understanding regarding the definition and use of the terms is not necessarily shared among all persons skilled in the art. For example, while "conductive pattern" is defined as "a figure formed by a conductive material" in JIS C 5603, many persons skilled in the art use, without notice, "conductive pattern" not as "figure" but as a term indicating "a conductor itself having a specific shape". Moreover, while "via" is defined as "hole only for interlayer connection" in JIS C 5603, many persons skilled in the art call, without notice, even a hole only for attachment of a component as a via. Since the applicant of the present patent application is a Japanese corporation, this specification is made pursuant to JIS C 5603 "as much as possible". However, for interpretation of the terms used in this specification, the above-described reality of the situation should be sufficiently considered and, in particular, neither interpretation that cavils at a word nor interpretation adverse to the technology disclosed herein should be made. The applicant may use, as required, a term that has been conventionally used. Furthermore, to avoid narrow construction or strict interpretation not matching the intention of the applicant, the applicant may use an unconventional term not explicitly defined in standards. In this case, to help understanding an unconventional term or a term not defined in standards, a non-limited example of a term defined in standards or a conventional term is provided.

The double-sided board is also called a two-layer substrate, and has a structure including one insulating plate (the insulating plate is generally called a core) and electrical conductors (the electrical conductors are normally metal and, in particular, metal foils) having a predetermined pattern and arranged on both surfaces of the insulating plate. A "layer" of the two-layer substrate is a "conductor layer", that is, a site where an electrical conductor can be arranged (in other words, a surface of the insulating plate).

The multilayer board has a structure in which two or more insulating plates (the two or more insulating plates are generally classified into a core and a prepreg) and electrical conductors (the electrical conductors are normally metal and, in particular, metal foils) having a predetermined pattern are alternately arranged. A "layer" of the multilayer board is a "conductor layer", that is, a site where an electrical conductor can be arranged (in other words, a surface of each of two insulating plates on the outermost sides and a boundary between adjacent insulating plates). An inner conductor layer as a boundary between the adjacent insulating plates is called an "inner layer".

The pattern of the electrical conductor of each conductor layer (that is, the conductive pattern) generally includes all or several ones of a trace, a land, and a plane. The trace is a fine conductive path for connecting different sites to each other in the conductive pattern, and is also called a track, a line, or the like. The land is a portion for use in attachment or connection of a component in the conductive pattern. In particular, a land for use in soldering a surface mount component is also called a pad. The plane is a portion, which has a relatively wide area, of the conductive pattern, and is used mainly for a power supply or ground. In the following, these terms of the trace, the land, and the plane are used not only as terms meaning "part of the pattern" but also as terms meaning part of an electrical conductor forming a conductive pattern. The electrical conductors of the conductor layers are electrically connected to each other via a plated through hole as required. The plated through hole is a hole extending in a direction penetrating through an insulating plate, that is, a thickness direction of an insulating plate, the inside of the plated through hole is covered with an electrical conductor and, furthermore, a land is normally formed at each of both ends of the plated through hole.

Since high-density wiring technology for printed wiring boards has advanced in recent years, insulation degradation due to a migration phenomenon in which the electrical conductor used for the printed wiring board migrates on or along an insulating material has been recognized as a problem. Migration based on an electrolytic phenomenon is called ion migration, and is classified into several types based on the site of occurrence and the outer appearance. In particular, when the insulating material is a fibrous base material, a type in which metal is deposited from the anode to the cathode along the fibrous base material is called conductive anodic filaments (CAF). Regarding CAF, please refer to, for example, Laura J. Turbini, "Conductive anodic filament (CAF) formation: an historic perspective", Circuit World, Vol. 32 No. 3, pp. 19-24,

https://doi.org/10.1108/03056120610700892. As factors responsible for the occurrence of CAF, the property of metal for use in the printed wiring board, electric field intensity, environmental temperature, environmental moisture, and so forth have been known.

As examples of a printed wiring board including an insulating plate including a fibrous base material, the following boards have been known: a paper phenolic board fabricated by impregnating paper with phenol resin, a paper epoxy board fabricated by impregnating paper with epoxy resin, a glass composite board fabricated by impregnating glass fiber cut into equal lengths with epoxy resin, a glass epoxy board fabricated by impregnating a glass-fiber-made cloth with epoxy resin, a composite board in a composite structure of a glass epoxy board and a paper epoxy board, and so forth. In the following, these boards are called as fiber substrate. The fiber substrate may have a structure as a double-sided board or a structure as a multilayer board.

Regarding these fiber substrates, it has been known that CAF tends to occur between plated through holes in the double-sided board and to occur between plated through holes and between a plated through hole and an electrical conductor arranged in an inner layer (an electrical conductor arranged in an inner layer is hereinafter referred to as an inner-layer conductor) in the multilayer board.

The factors responsible for the occurrence of CAF are the property of metal for use in the printed wiring board, electric field intensity, environmental temperature, environmental moisture, and so forth. Therefore, known countermeasures to avoid a failure of the printed wiring board due to

CAF include:
1) using materials in which CAF is difficult to occur,
2) reducing the environmental temperature,
3) reducing the environmental moisture,
4) Sufficiently ensuring a distance between plated through holes,
5) Sufficiently ensuring a distance between a plated through hole and an inner-layer conductor,
6) Sufficiently ensuring a distance between a ground and a plated through hole with a high potential, and
7) not arranging two or more plated through holes in a direction in which the fibrous base material extends.

As described above, the directional module having a printed wiring board incorporated therein is attached near the drill bit. In view of cost, it is difficult to adopt the countermeasure 1). Since the drill bit proceeds to deeply drill into underground, the countermeasure 2) is impossible or unrealistic. As hermetically sealed in a pressure container, the directional module is less prone to receiving the influence of environmental moisture, strict moisture management is not necessarily performed at the time of assembling the pressure container. In practice, it is difficult to perform strict moisture management in view of cost. Even if strict moisture management is performed, it is difficult to completely remove moisture. Once the directional module is hermetically sealed in the pressure container, the directional module is exposed for a long time to environmental moisture at the time of assembly. Therefore, according to the countermeasure 3), a sufficient effect is unlikely. Since the directional module is attached near the drill bit, the size of the drill module has a limit. Therefore, the size of the printed wiring board to be incorporated inside the directional module also has a limit. That is, the countermeasures 4) to 7) are difficult because of design restrictions. In this manner, regarding the printed wiring board to be incorporated in the directional module, it is often impossible to adopt the above-described countermeasures known to avoid a failure of the printed wiring board due to CAF.

### BRIEF SUMMARY OF THE INVENTION

In view of this technical problem, a printed wiring board is herein disclosed for which countermeasures against failures due to CAF have been taken, in particular, a printed wiring board is herein disclosed which has a CAF-resistant wiring structure in which two electrical conductors, different from each other, are present in a range where the two electrical conductor can be short-circuited each other by a conductive anode filament and are arranged in a direction in which a fibrous base material extends.

Technical matters described herein are neither intended to explicitly or implicitly limit inventions of the claims nor intended to allow any person other than those benefiting from the present invention (for example, the applicant and proprietors) to limit the inventions of the claims, and are merely provided to facilitate understanding of the gist of the present invention. The outline of the present invention from another viewpoint can be appreciated, for example, from the claims at the time of filing of this patent application.

The printed wiring board of the present disclosure includes a fiber-containing insulating plate including a fibrous base material and a CAF-resistant wiring structure. The CAF-resistant wiring structure includes a ground conductor, a first electrical conductor included in a power supply wire, and a second electrical conductor included in a signal wire. The first electrical conductor and the second electrical conductor are present in a range where the first electrical conductor and the second electrical conductor can be short-circuited each other by a conductive anode filament. Furthermore, the ground conductor, the first electrical conductor, and the second electrical conductor are arranged in a direction in which the fibrous base material extends in order of the first electrical conductor, the ground conductor, and then the second electrical conductor. In this manner, the printed wiring board of the present disclosure is characterized in that the ground conductor is arranged on purpose near the first electrical conductor included in the power supply wire. In this manner, the printed wiring board of the present disclosure has a feature against the above-described measure 6).

These and other objects, features and advantages of the present invention will become apparent from the detailed description taken in conjunction with the accompanying drawings.

### EFFECTS OF THE INVENTION

The disclosed printed wiring board has resistance to failures due to CAF.

### BRIEF DESCRIPTION OF THE DRAWINGS

The subject matter, which is regarded as the invention, is particularly pointed out and distinctly claimed in the claims at the conclusion of the specification. The present invention itself, and manner in which it may be made or used, if any, may be better understood after a review of the following description in connection with the accompanying drawings in which:
FIG. 1 depicts an embodiment (first example) of a printed wiring board.
FIG. 2 depicts an embodiment (second example) of a printed wiring board.
FIG. 3 depicts an embodiment (third example) of a printed wiring board.
FIG. 4 depicts an embodiment (fourth example) of a printed wiring board.
FIG. 5 depicts an embodiment (fifth example) of a printed wiring board.
FIG. 6 depicts an embodiment (sixth example) of a printed wiring board.
FIG. 7 depicts an embodiment (seventh example) of a printed wiring board.
FIG. 8 depicts an embodiment (eighth example) of a printed wiring board.
FIG. 9 depicts an embodiment (ninth example) of a printed wiring board.
FIG. 10 depicts an embodiment (tenth example) of a printed wiring board.
FIG. 11 depicts an embodiment (eleventh example) of a printed wiring board.
FIG. 12 depicts an embodiment (twelfth example) of a printed wiring board.
FIG. 13 depicts an embodiment (thirteenth example) of a printed wiring board.
FIG. 14 depicts an embodiment (fourteenth example) of a printed wiring board.
FIG. 15 depicts an embodiment (fifteenth example) of a printed wiring board.
FIG. 16 depicts an embodiment (sixteenth example) of a printed wiring board.
FIG. 17 depicts an embodiment (seventeenth example) of a printed wiring board.
FIG. 18 depicts an embodiment (eighteenth example) of a printed wiring board.
FIG. 19 depicts an embodiment (nineteenth example) of a printed wiring board.
FIG. 20 depicts an embodiment (twentieth example) of a printed wiring board.

### LIST OF REFERENCE NUMERALS

With regard to reference numerals used, the following numbering is used throughout the drawings.
1: printed wiring board
11: insulating plate
11a: fibrous base material
13: power supply wire
13a: first conductor
15: signal wire
15a: second conductor
17: ground conductor

### DETAILED DESCRIPTION

With reference to the drawings, embodiments of the printed wiring board herein disclosed are described. The drawings are merely for the purpose of understanding the embodiments, so the dimensions of each component depicted are not necessarily equal to the actual dimensions. In view of clarifying the main points of the embodiments, depiction and description of components that are considered to be necessary or possibly necessary in practice but are nonessential in the embodiments (such as a solder resist layer, silk, and so forth) are omitted. In each drawing, in consideration of ease of viewability of the drawing, only several ones of two or more identical components are each provided with a reference character. In the following, N is a positive integer defined in advance.

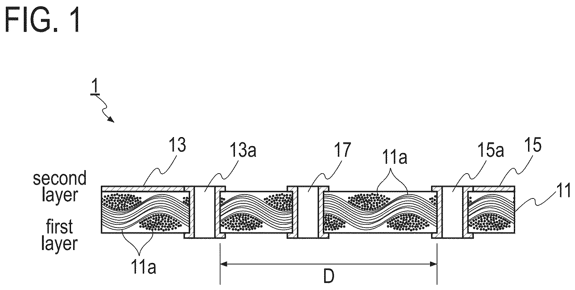

A printed wiring board 1 of the embodiments (refer to FIG. 1 to FIG. 20) is a component included in a circuit device for measuring the orientation of a drill bit for use in underground excavation (for example, the above-described directional module), and is a printed wiring board operating in a temperature environment at least equal to or higher than 150 degrees Celsius and equal to or lower than 200 degrees Celsius. The printed wiring board 1 includes N insulating plates 11, a power supply line 13, a signal line 15, and a ground conductor 17.

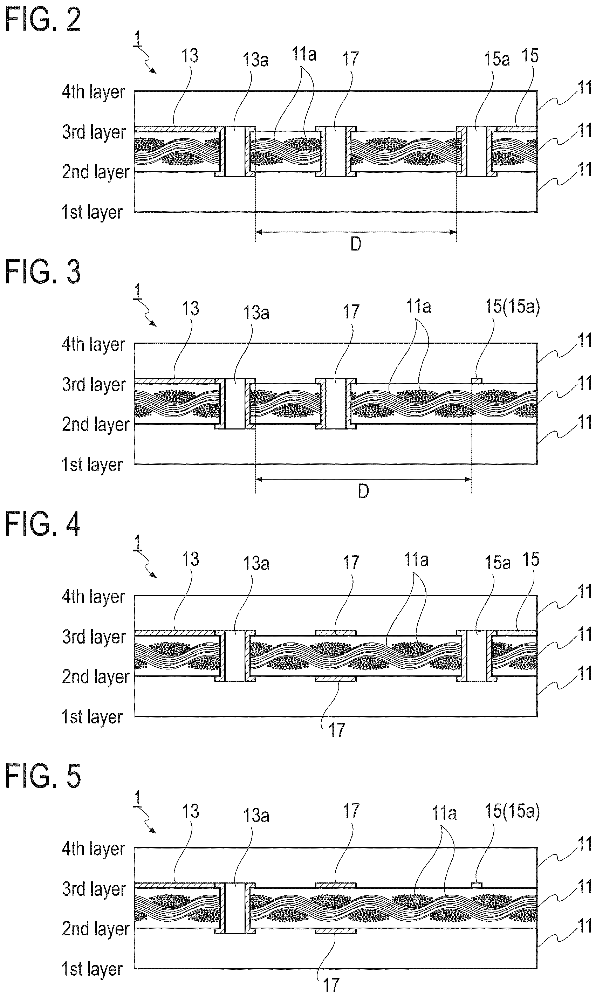

In the case of N = 1, the printed wiring board 1 includes one insulating plate 11 and is a double-sided board. This one insulating plate 11 is a fiber-containing plate including a fibrous base material 11a. In the case of N ≥ 2, the printed wiring board 1 includes N insulating plates 11 and is a multilayer board. Examples of the multilayer board include a through-hole multilayer board (specifically, a multilayer board in which specific two or more layers are connected to each other with the use of a plated through hole penetrating the lowermost layer from the uppermost layer and a land), an interstitial via hole (IVH) multilayer board (specifically, a multilayer board in which specific two or more layers are connected to each other with the use of an interstitial via hole), and a buildup board (specifically, a multilayer board fabricated by repeating formation of an insulating layer and a conductive layer, hole-boring process, wiring, and so forth). At least one insulating plate 11 of the N insulating plates 11 is a fiber-containing plate including the fibrous base material 11a. The fibrous base material 11a is, for example, paper or glass fiber. As the printed wiring board 1, the above-described example of a fiber substrate can be adopted. FIG. 1 schematically depicts the printed wiring board 1 that is a glass epoxy board, and FIG. 2 to FIG. 20 schematically each depict the printed wiring board 1 including the insulating plate 11 fabricated by impregnating a glass-fiber-made cloth with epoxy resin.

The power supply line 13 is an electrical conductor for power supply from a direct-current power supply (not depicted) scheduled to be attached to the printed wiring board 1 to an electronic component (not depicted) scheduled to be mounted on the printed wiring board 1. The power supply line 13 includes all or several components among an interlayer connection conductor, a trace, a land, and a plane. In general, the material of the power supply line 13 is copper. The power supply line 13 includes a first conductor 13a that is, in the case of N = 1, an interlayer connection conductor penetrating through the fiber-containing plate (that is, the insulating plate 11 including the fibrous base material 11a) and is, in the case of N ≥ 2, an interlayer connection conductor penetrating through the fiber-containing plate or an inner-layer conductor on the fiber-containing plate.

The signal line 15 is an electrical conductor for transmitting a current signal to or from the electronic component (not depicted) scheduled to be mounted on the printed wiring board 1. The signal line 15 includes all or several components among an interlayer connection conductor, a trace, and a pad. In general, the material of the signal line 15 is copper. The signal line 15 includes a second conductor 15a that is, in the case of N = 1, an interlayer connection conductor penetrating through the fiber-containing plate (that is, the insulating plate 11 including the fibrous base material 11a) and is, in the case of N ≥ 2, an interlayer connection conductor penetrating through the fiber-containing plate or an inner-layer conductor on the fiber-containing plate.

The ground conductor 17 is, in the case of N = 1, an interlayer connection conductor penetrating through the fiber-containing plate (that is, the insulating plate 11 including the fibrous base material 11a) and is, in the case of N ≥ 2, an interlayer connection conductor penetrating through the fiber-containing plate or an inner-layer conductor on the fiber-containing plate.

Examples of the above-described interlayer connection conductor include a through hole for use in insertion and soldering of a terminal of an electronic component-a plated through hole and a landless through hole-, , and a through hole for electrically connecting electrical conductors of two or more layers to each other-a via hole, a conformal via, a filled via, a staggered via, a stacked via, a skip via, a plugged base via, a landless via-. Examples of the via hole include a through hole via penetrating through all layers and all insulating plates 11, and an interstitial via hole. Examples of the interstitial via hole include a blind via and a buried via. Furthermore, the inside of the plated through hole may be a gap, may be filled with an electrical conductor, or may be filled with an insulator.

Examples of the inner-layer conductor as the first conductor 13a or the ground conductor 17 include a trace arranged in an inner layer, a land arranged in an inner layer, and a plane arranged in an inner layer. Examples of the inner-layer conductor as the second conductor 15a include a trace arranged in an inner layer and a land arranged in an inner layer.

As described above, the printed wiring board 1 is characterized by having a CAF-resistant wiring structure in which the first conductor 13a belonging to the power supply line 13 and the second conductor 15a belonging to the signal line 15 are present in a range where the first conductor 13a and the second conductor 15a can be short-circuited each other by CAF and are arranged in a direction in which the fibrous base material 11a extends. That is, a shortest distance D between the first conductor 13a and the second conductor 15a is shorter than a distance D_{CAF} at which CAF can reach the second conductor 15a from the first conductor 13a. In particular, the shortest distance D is far shorter than a distance D_{useful} at which CAF can extend from the first conductor 13a until the printed wiring board 1 reaches a useful life required in design. Furthermore, the ground conductor 17, the first conductor 13a, and the second conductor 15a are arranged in a direction in which the fibrous base material 11a extends. In the wiring structure allowing the occurrence and growth of CAF, resistance to CAF is achieved by the ground conductor 17, the first conductor 13a, and the second conductor 15a arranged in order of the first conductor 13a, the ground conductor 17, and then the second conductor 15a in the direction in which the fibrous base material 11a extends. In consideration of the possibility of CAF growing from the second conductor 15a toward the ground conductor 17, the ground conductor 17 is desirably closer to the first conductor 13a than the second conductor 15a.

The applicant of the present patent application conducted an accelerated degradation test on conditions that the power supply voltage of the direct-current power supply was 28 volts, the driving voltage of the electronic components was 3.3 volts, the environmental temperature was 185 degrees, and the total energization time was 2000 hours, and confirmed that the distance D_{CAF} at which CAF could reach the second conductor 15a from the first conductor 13a was 4 mm.

According to the CAF-resistant wiring structure, CAF extending from the first conductor 13a belonging to the power supply line 13 reaches the ground conductor 17 in the long run, and the first conductor 13a and the ground conductor 17 are short-circuited each other. In general, since CAF is very thin, CAF is burned out at the instant when the first conductor 13a and the ground conductor 17 become short-circuited. This instantaneous phenomenon does not provide a significant voltage drop to the driving voltage of the electronic component supplied with power from the direct-current power supply. Therefore, a circuit device for measuring the orientation of the drill bit for use in underground excavation (for example, the above-described directional module) can continuously operate normally. To instantaneously make CAF burned out, a potential difference between the first conductor 13a and the ground conductor 17 is preferably equal to or higher than 24 volts, in other words, the power supply voltage of the direct-current power supply is preferably equal to or higher than 24 volts. Since the ground conductor 17 inhibits CAF from reaching the second conductor 15a belonging to the signal line 15, a short-circuit current occurring due to short-circuit between the first conductor 13a and the second conductor 15a does not flow into the electronic component. That is, erroneous activation of the electronic component due to a short-circuit current working as a noise can be prevented and damages the short-circuit current provides to the electronic component can be prevented in advance, thereby extending the life of the printed wiring board 1. Whereas the useful life of the printed wiring board of prior art (that is, a period in which a failure of the printed wiring board due to CAF does not occur) is 1000 hours, the useful life of the printed wiring board 1 disclosed herein is 2000 hours according to the above-described accelerated degradation test.

In view of inhibiting the growth of CAF, the ground conductor 17 in a direction orthogonal to a direction of passing through the first conductor 13a and the second conductor 15a is desirably larger in size than one of the first conductor 13a and the second conductor 15a, whichever is not smaller.

Since exhaustively depicting all conceivable types of structure of the printed wiring board 1 is not practical, several embodiments are depicted in FIG. 1 to FIG. 20. FIG. 1 depicts an example in the case of N = 1, and FIG. 2 to FIG. 20 each depict an example in the case of N ≥ 2. In FIG. 2 to FIG. 20, the insulating plate 11 where the fibrous base material 11a is not depicted may be a fiber-containing plate or a fiber-non-containing plate. The position and the pattern of the power supply line 13 each have no limit. The position and the pattern of the signal line 15 each have no limit.

In the example of FIG. 1, the first conductor 13a is a through hole via, the second conductor 15a is a through hole via, and the ground conductor 17 is a through hole via.

In the example of FIG. 2, the first conductor 13a is a buried via, the second conductor 15a is a buried via, and the ground conductor 17 is a buried via.

In the example of FIG. 3, the first conductor 13a is a buried via, the second conductor 15a is an inner-layer trace, and the ground conductor 17 is a buried via.

In the example of FIG. 4, the first conductor 13a is a buried via, the second conductor 15a is a buried via, and the ground conductor 17 is an inner-layer trace. In the case where the first conductor 13a is a via and the ground conductor 17 is an inner-layer trace, the ground conductor 17 preferably includes at least two inner-layer traces. In particular, at least two inner-layer traces are preferably arranged on both surfaces of the insulating plate 11 including the fibrous base material 11a and at the same position in a thickness direction of the insulating plate 11. This technical matter applies also to other examples in which the first conductor 13a is a via and the ground conductor 17 is an inner-layer trace.

In the example of FIG. 5, the first conductor 13a is a buried via, the second conductor 15a is an inner-layer trace, and the ground conductor 17 is an inner-layer trace.

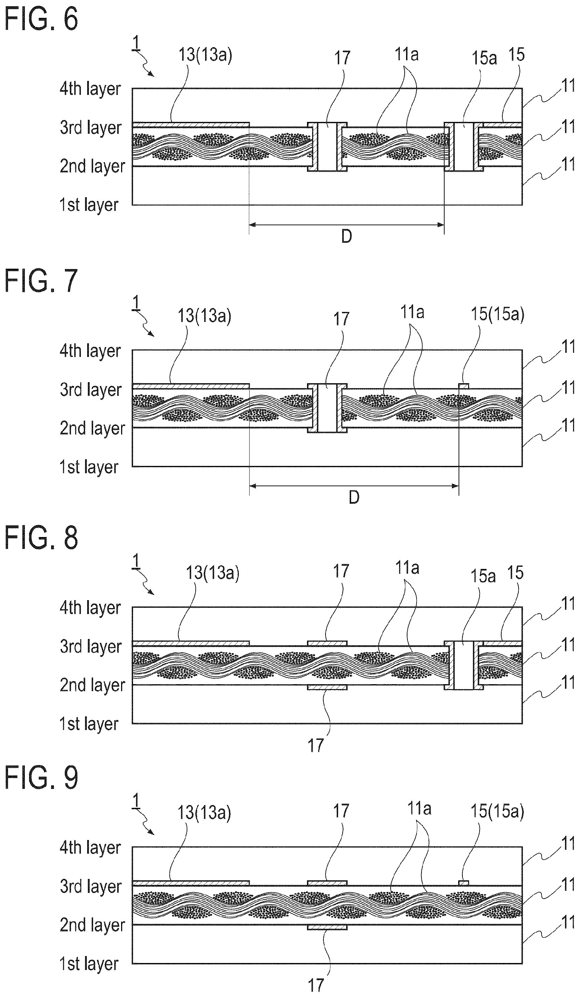

In the example of FIG. 6, the first conductor 13a is an inner-layer trace, the second conductor 15a is a buried via, and the ground conductor 17 is a buried via.

In the example of FIG. 7, the first conductor 13a is an inner-layer trace, the second conductor 15a is an inner-layer trace, and the ground conductor 17 is a buried via.

In the example of FIG. 8, the first conductor 13a is an inner-layer trace, the second conductor 15a is a buried via, and the ground conductor 17 is an inner-layer trace.

In the example of FIG. 9, the first conductor 13a is an inner-layer trace, the second conductor 15a is an inner-layer trace, and the ground conductor 17 is an inner-layer trace.

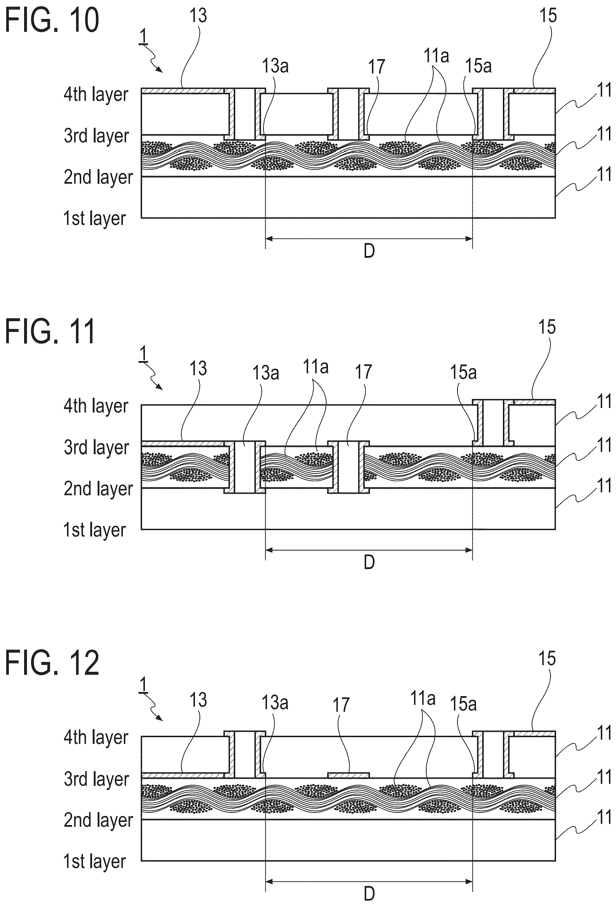

In the example of FIG. 10, the first conductor 13a is a land of a blind via, the second conductor 15a is a land of a blind via, and the ground conductor 17 is a land of a blind via. In the case where the insulating plate 11 positioned at the uppermost of the printed wiring board 1 depicted in FIG. 10 also includes the fibrous base material 11a, the first conductor 13a is a blind via, the second conductor 15a is a blind via, and the ground conductor 17 is a blind via, when viewed from the insulating plate 11 positioned at the uppermost of the printed wiring board 1. As can be seen from this, each of the first conductor 13a, the second conductor 15a, and the ground conductor 17 is not uniquely interpreted.

In the example of FIG. 11, the first conductor 13a is a buried via, the second conductor 15a is a land of a blind via, and the ground conductor 17 is a buried via.

In the example of FIG. 12, the first conductor 13a is a land of a blind via, the second conductor 15a is a land of a blind via, and the ground conductor 17 is an inner-layer trace.

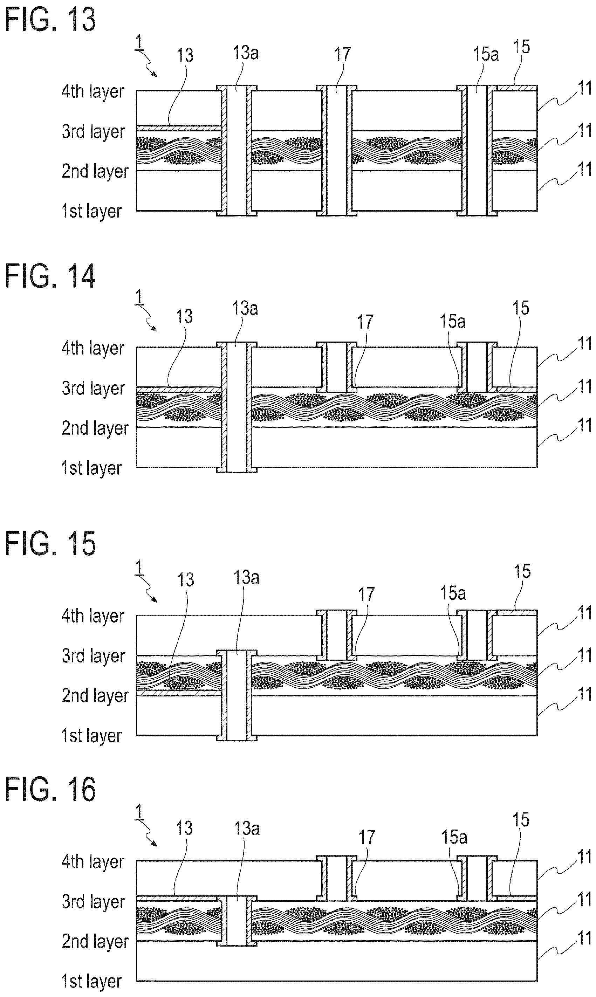

In the example of FIG. 13, the first conductor 13a is a through hole via, the second conductor 15a is a through hole via, and the ground conductor 17 is a through hole via. In the case where all insulating plates 11 include the fibrous base material 11a, the embodiment depicted in FIG. 13 would be the simplest example.

In the example of FIG. 14, the first conductor 13a is a through hole via, the second conductor 15a is a land of a blind via, and the ground conductor 17 is a land of a blind via.

In the example of FIG. 15, the first conductor 13a is a blind via, the second conductor 15a is a land of a blind via, and the ground conductor 17 is a land of a blind via.

In the example of FIG. 16, the first conductor 13a is a buried via, the second conductor 15a is a land of a blind via, and the ground conductor 17 is a land of a blind via.

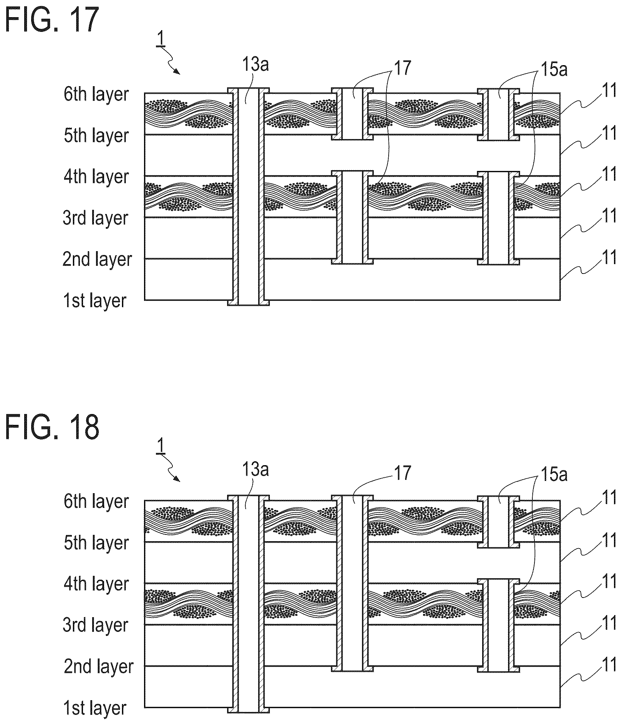

In the example of FIG. 17, the first conductor 13a is a through hole via, the second conductor 15a is a blind via and a buried via, and the ground conductor 17 is a blind via and a buried via. As can be seen from this, each of the first conductor 13a, the second conductor 15a, and the ground conductor 17 is not necessarily a single electrical conductor. In particular, the shape and the number of ground conductors 17 have no limit as long as the growth of CAF from the first conductor 13a to the second conductor 15a can be inhibited.

In the example of FIG. 18, the first conductor 13a is a through hole via, the second conductor 15a is a blind via and a buried via, and the ground conductor 17 is a through hole via.

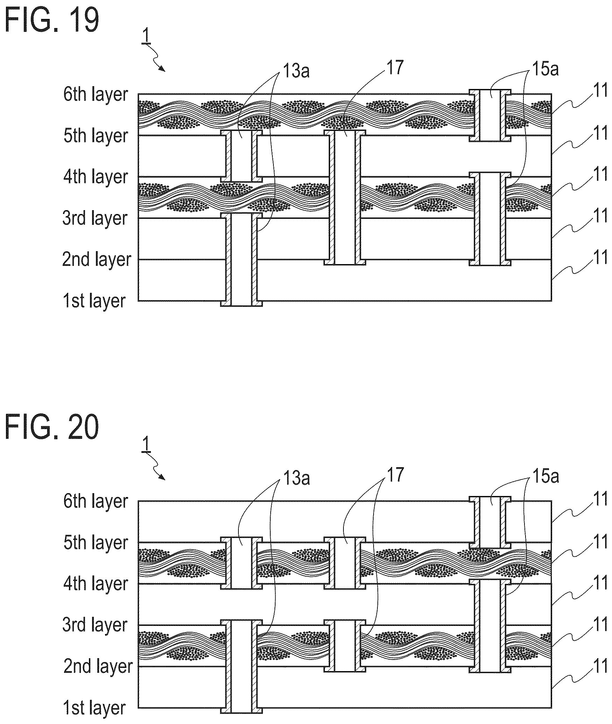

In the example of FIG. 19, the first conductor 13a is a blind via and a buried via, the second conductor 15a is a blind via and a buried via, and the ground conductor 17 is a buried via.

In the example of FIG. 20, the first conductor 13a is a blind via and a buried via, the second conductor 15a is a blind via and a buried via, and the ground conductor 17 is two buried vias.

### <Addendum 1>

Technical features disclosed in the above-described various types of embodiments and the modifications thereof are not always mutually exclusive. A technical feature of a given embodiment or a modification thereof may be applied to a technical feature of another embodiment or a modification thereof as far as there is no contradiction from a technical viewpoint.

The claims at the time of filing of the present application do not always exhaustively claim all the inventions disclosed in this specification. In this respect, the applicant of the present application should not be understood or interpreted as waiving, before the filing, the right to obtain a patent for an invention not claimed at the time of the filing of the present application. The applicant of the present application retains the right to obtain a patent for an invention not claimed in the present application, the right to file a divisional application for the invention, the right to claim the invention by amendment, and all other rights as far as the law or the treaty of a country or a region which has accepted the filing of the present application allows. However, this shall not apply if the applicant of the present application explicitly and determinately declares a contrary intention.

In the printed wiring board to be claimed, a printed circuit board is not excluded from its scope of protection. The printed circuit board is generally a designation of a printed wiring board where a printed component or an electronic component is mounted. That is, the printed circuit board includes a printed wiring board and a printed component or an electronic component mounted on the printed wiring board. Therefore, the printed circuit board including the printed wiring board disclosed herein implements the printed wiring board disclosed herein.

Examples of the summary of the present disclosure based on another viewpoint are as follows.

A printed wiring board based on a first viewpoint includes:
N insulating plates, N being a predetermined positive integer, the printed wiring board being a double-sided board in a case of N = 1 and a multilayer board in a case of N ≥ 2, and at least one insulating plate of the N insulating plates being a fiber-containing plate including a fibrous base material;
a power supply line, the power supply being an electrical conductor for power supply from a direct-current power supply to be attached to the printed wiring board to an electronic component to be mounted on the printed wiring board;
a signal line, the signal line being an electrical conductor for a flow of a current signal to or from the electronic component; and
a ground conductor, the ground conductor being an interlayer connection conductor penetrating through the fiber-containing plate in the case of N = 1 and an interlayer connection conductor penetrating through the fiber-containing plate or an inner-layer conductor on the fiber-containing plate in the case of N ≥ 2, in which
the power supply line includes a first conductor, the first conductor being an interlayer connection conductor penetrating through the fiber-containing plate in the case of N = 1 and an interlayer connection conductor penetrating through the fiber-containing plate or an inner-layer conductor on the fiber-containing plate in the case of N ≥ 2,
the signal line includes a second conductor, the second conductor being an interlayer connection conductor penetrating through the fiber-containing plate in the case of N = 1 and an interlayer connection conductor penetrating through the fiber-containing plate or an inner-layer conductor on the fiber-containing plate in the case of N ≥ 2,
a shortest distance between the first conductor and the second conductor is shorter than a distance at which a conductive anode filament can reach the second conductor from the first conductor, and
the ground conductor, the first conductor, and the second conductor are arranged in order of the first conductor, the ground conductor, and then the second conductor, in a direction in which the fibrous base material extends.

In a printed wiring board based on a second viewpoint, the printed wiring board being based on the first viewpoint,
the distance at which the conductive anode filament can reach the second conductor from the first conductor is 4 mm.

In a printed wiring board based on a third viewpoint, the printed wiring board being based on the first viewpoint or the second viewpoint,
the direct-current power supply has a power supply voltage equal to or higher than 24 volts.

In a printed wiring board based on a fourth viewpoint, the printed wiring board being based on any one of the first viewpoint to the third viewpoint,
the ground conductor in a direction orthogonal to a direction of passing through the first conductor and the second conductor is larger in size than one of the first conductor and the second conductor, whichever is not smaller.

In a printed wiring board based on a fifth viewpoint, the printed wiring board being based on any one of the first viewpoint to the fourth viewpoint,
the ground conductor is closer to the first conductor than the second conductor.

In a printed wiring board based on a sixth viewpoint, the printed wiring board being based on any one of the first viewpoint to the fifth viewpoint,
the printed wiring board is a printed wiring board operating in a temperature environment at least equal to or higher than 150 degrees Celsius and equal to or lower than 200 degrees Celsius.

In a printed wiring board based on a seventh viewpoint, the printed wiring board being based on any one of the first viewpoint to the sixth viewpoint,
the printed wiring board is a component included in a circuit device for measuring orientation of a drill bit.

### <Addendum 2>

While the present invention has been described with reference to the exemplary embodiments, it will be understood by those skilled in the art that various changes may be made and equivalents may be substituted for elements thereof without departing from the scope of the present invention. In addition, many modifications may be made to adapt a particular system, device, or component thereof to the teachings of the present invention without departing from the essential scope thereof. Therefore, it is intended that the present invention is not limited to the particular embodiment disclosed for carrying out this invention, but that the present invention will include all embodiments falling within the scope of the appended claims.

Moreover, the use of the terms "first", "second", and the like, when used in the present specification and/or the appended claims, do not denote any order or importance, but rather the terms "first", "second", and the like are used to distinguish one element from another. The terminology used in the present specification is for the purpose of describing the embodiments and is not intended to limit the present invention. It will be further understood that the terms "comprise" and "include" and inflected forms thereof, when used in the present specification and/or the appended claims, specify the presence of stated features, steps, operations, elements, and/or components, but do not preclude the presence or addition of one or more other features, steps, operations, elements, components, and/or groups thereof. The term "and/or", if any, includes any and all combinations of one or more of the associated listed items. In the claims and the specification, unless otherwise specified, "connect", "join", "couple", "interlock", or synonyms therefor and all the word forms thereof do not necessarily deny the presence of one or more intermediate elements between, for example, two elements "connected" or "joined" to each other or "interlocked" with each other. In the claims and the specification, the term "any", if any, is to be understood as a term synonymous with a universal quantifier ∀ unless otherwise specified. For example, the expression "for any X" has the same meaning as "for all X" or "for each X". Expressions like "at least one of A, B and C", "at least one of A, B or C", and "at least one of A, B and/or C", if any, mean arbitrarily choosing one member from a set P obtained by removing an empty set ϕ from a power set 2^{S} of a set S including all listed elements as members, unless otherwise defined. In this example, S = {A, B, C}, 2^{S} = {ϕ, {A}, {B}, {C}, {A, B}, {A, C}, {B, C}, {A, B, C} }, and P = { {A}, {B}, {C}, {A, B}, {A, C}, {B, C}, {A, B, C}}. The example means that one member (for example, {A, C}) is arbitrarily chosen from the set P.

Unless otherwise defined, all terms (including technical and scientific terms) used in the present specification have the same meanings as commonly understood by those skilled in the art to which the present invention belongs. It will be further understood that terms, such as those defined in commonly used dictionaries, should be interpreted as having meanings that are consistent with their meanings in the context of the relevant art and the present disclosure and should not be interpreted in an idealized or overly formal sense unless explicitly so defined herein.

In describing the present invention, it will be understood that a number of techniques and steps are disclosed. Each of these has individual benefit and each can also be used in combination with one or more, or in some cases all, of the other disclosed techniques. Accordingly, for the sake of clarity, the present specification will refrain from explaining every possible combination of the individual techniques or steps. Nevertheless, the specification and claims should be read with the understanding that such combinations are entirely within the scope of the present invention and the claims.

The corresponding structures, materials, acts, and equivalents of all means or steps plus function elements in the claims below, if any, are intended to include any structure, material, or act for performing the function in combination with other elements.

Although the embodiments of the present invention have been described above, the present invention is not limited to the embodiments. Various modifications and variations may be made without departing from the gist of the present invention. The chosen and described embodiments are for illustrating the principles of the present invention and its practical application. The present invention is used in various embodiments and with various modifications or variations, and the various modifications or variations are tailored to suit an expected purpose. All such modifications and variations are intended to be included in the scope of the present invention as determined by the appended claims and are intended to be provided with comparable protection when interpreted in accordance with the breadth to which they are fairly, legally, and equitably entitled.

## Claims

1. A printed wiring board comprising:
N insulating plates, N being a predetermined positive integer, the printed wiring board being a double-sided board in a case of N = 1 and a multilayer board in a case of N ≥ 2, and at least one insulating plate of the N insulating plates being a fiber-containing plate including a fibrous base material;
a power supply line, the power supply being an electrical conductor for power supply from a direct-current power supply to be attached to the printed wiring board to an electronic component to be mounted on the printed wiring board;
a signal line, the signal line being an electrical conductor for a flow of a current signal to or from the electronic component; and
a ground conductor, the ground conductor being an interlayer connection conductor penetrating through the fiber-containing plate in the case of N = 1 and an interlayer connection conductor penetrating through the fiber-containing plate or an inner-layer conductor on the fiber-containing plate in the case of N ≥ 2, wherein
the power supply line includes a first conductor, the first conductor being an interlayer connection conductor penetrating through the fiber-containing plate in the case of N = 1 and an interlayer connection conductor penetrating through the fiber-containing plate or an inner-layer conductor on the fiber-containing plate in the case of N ≥ 2,
the signal line includes a second conductor, the second conductor being an interlayer connection conductor penetrating through the fiber-containing plate in the case of N = 1 and an interlayer connection conductor penetrating through the fiber-containing plate or an inner-layer conductor on the fiber-containing plate in the case of N ≥ 2,
a shortest distance between the first conductor and the second conductor is shorter than a distance at which a conductive anode filament can reach the second conductor from the first conductor, and
the ground conductor, the first conductor, and the second conductor are arranged in order of the first conductor, the ground conductor, and then the second conductor, in a direction in which the fibrous base material extends.

2. The printed wiring board according to Claim 1, wherein the distance at which the conductive anode filament can reach the second conductor from the first conductor is 4 mm.

3. The printed wiring board according to Claim 1 or 2, wherein the direct-current power supply has a power supply voltage equal to or higher than 24 volts.

4. The printed wiring board according to any one of Claims 1 to 3, wherein the ground conductor in a direction orthogonal to a direction of passing through the first conductor and the second conductor is larger in size than one of the first conductor and the second conductor, whichever is not smaller.

5. The printed wiring board according to any one of Claims 1 to 4, wherein
the ground conductor is closer to the first conductor than the second conductor.

6. The printed wiring board according to any one of Claims 1 to 5, wherein
the printed wiring board is a printed wiring board operating in a temperature environment at least equal to or higher than 150 degrees Celsius and equal to or lower than 200 degrees Celsius.

7. The printed wiring board according to any one of Claims 1 to 6, wherein
the printed wiring board is a component included in a circuit device for measuring orientation of a drill bit.
